Europäisches Patentamt

European Patent Office

Office européen des brevets

(19)

(11) Numéro de publication: **0 069 706 B1**

(12) **FASCICULE DE BREVET EUROPEEN**

(45) Date de publication du fascicule du brevet:
**22.05.85**

(51) Int. Cl.⁴: **C 04 B 41/45,** C 23 C 8/28,
B 23 B 27/14

(21) Numéro de dépôt: **82810287.1**

(22) Date de dépôt: **02.07.82**

(54) **Pièce d'usure en matériau réfractaire.**

(30) Priorité: **02.07.81 CH 4371/81**

(43) Date de publication de la demande:
**12.01.83 Bulletin 83/2**

(45) Mention de la délivrance du brevet:
**22.05.85 Bulletin 85/21**

(84) Etats contractants désignés:
**DE FR GB IT**

(56) Documents cités:
**EP - A - 0 015 451
FR - A - 2 144 823
FR - A - 2 302 805
FR - A - 2 313 161
FR - A - 2 454 903**

**Le dossier contient des informations techniques
présentées postérieurement au dépôt de la demande et
ne figurant pas dans le présent fascicule.**

(73) Titulaire: **STELLRAM S.A., Route de l'Etraz,
CH-1260 Nyon, Vaud (CH)**

(72) Inventeur: **Hauser, Charles, En Nuyerattes,
CH-1261 Genolier, Vaud (CH)**

(74) Mandataire: **Micheli, Michel-Pierre et al, MICHELI &
CIE 118, Rue du Rhône Case Postale 47,
CH-1211 Genève 6 (CH)**

ACTORUM AG

# Description

La présente invention se rapporte à une pièce d'usure en matériau réfractaire, par exemple un outil de coupe, recouverte au moins aux endroits soumis à usure d'un revêtement de protection.

Par pièce en matériau réfractaire, on entend ici des pièces constituées par un mélange de particules réfractaires, par exemple des carbures, nitrures, borures, oxydes, etc.

Le matériau réfractaire est généralement fritté, et peut en outre comporter un liant métallique, par exemple du Fe, Co, Ni, Ti, etc. Ces pièces peuvent être par exemple des plaquettes ou outils de coupe pour l'usinage de matériaux durs tels que l'acier.

Il est déjà connu, notamment du document FR-A-2 144 823, que l'on peut augmenter la résistance à l'usure de pièces en matériau réfractaire en recouvrant leur surface, ou au moins leurs portions soumises à usure, par un revêtement protecteur pouvant comporter une ou plusieurs couches de composés réfractaires, tels que des oxydes, nitrures et borures d'éléments des groupes III à VI du Tableau Périodique.

En poursuivant ces recherches, le présent inventeur a mis en évidence le fait que certains composés particuliers de l'aluminium, plus particulièrement les oxyborures et borures supérieurs, constituent un revêtement protecteur permettant d'améliorer encore les caractéristiques de résistance à l'usure des pièces en matériau réfractaire définies plus haut.

En conséquence, l'objet de cette invention consiste en une pièce d'usure en matériau réfractaire, recouverte au moins aux endroits soumis à l'usure d'un revêtement protecteur, caractérisée par le fait que la couche externe du revêtement est constituée par au moins un composé de l'aluminium choisi parmi les borures supérieurs de formule $Al_n$, où n = 10 ou 12, et les oxyborures supérieurs de formule $AlOB_m$, où m est égal ou supérieur à 8.

La couche externe en un composé de l'aluminium peut être appliquée soit directement sur la pièce en matériau réfractaire, soit sur d'autres couches appliquées préalablement de façon connue, telles que carbures, nitrures, borures, oxydes, etc. d'éléments des groupes III à VI.

Les borures et oxyborures supérieurs d'aluminium présentent une résistance mécanique élevée, tant du point de vue déformation que du point de vue résistance aux chocs et à l'usure. De plus, leurs propriétés telles que les points de fusion, les duretés, les résistances à l'oxydation, etc. s'accroissent en fonction du degré de boruration de l'aluminium.

Une couche externe constituée par un composé de l'aluminium tel qu'un oxyborure ou un borure supérieur permet également d'obtenir une meilleure uniformité de la surface, ce qui tend à diminuer la résistance au frottement et par là la température de travail de l'outil. Les propriétés de résistance à l'usure et la durée de vie de celui-ci sont donc améliorées respectivement augmentées.

Le choix de couches sous-jacentes permet le cas échéant d'améliorer d'autres caractéristiques de l'outil telle que sa résistance à l'oxydation ou l'adhérance du revêtement protecteur.

Les couches d'oxyborure et de borure d'aluminium sont obtenues de préférence par déposition chimique en phase gazeuse (CVD) selon les techniques bien connues, et dont les conditions peuvent être aisément déterminées par l'homme du métier.

D'une manière générale, ces dépôts sont effectués entre 900 et 1200°C, les produits de départ comprenant de l'hydrogène, un halogénure de l'élément choisi et un composé boré, par exemple du tétrachlorure de bore.

D'autres méthodes connues, telles que le dépôt physique en phase vapeur ou le sputtering peuvent aussi être utilisés.

Selon les résultats recherchés, le revêtement protecteur peut être obtenu en une seule opération ou en plusieurs étapes, chaque étape correspondant au dépôt d'une des couches désirées. Le revêtement peut en effet comporter plusieurs couches superposées chacune en un composé de l'aluminium précité ou alternées avec d'autres couches connues du type carbures, nitrures, oxydes, etc.

La présente invention sera maintenant illustrée en référence aux exemples comparatifs qui suivent:

*Exemple 1*

Deux plaquettes de coupe standard ont été utilisées pour ce premier essai, la plaquette (A) étant recouverte d'une couche de TiC, et la plaquette (B) étant munie d'un revêtement d'une épaisseur totale équivalente mais comprenant une couche de TiC et une couche externe d'oxyborure supérieur d'aluminium de 6 $\mu$, cette dernière ayant été déposée par CVD, dans les conditions suivantes:

| | |
|---|---|
| $BCl_3$ | 0,400 l/min |
| $AlCl_3$ | 0,400 l/min |
| $H_2$ | 15 l/min |
| $CO_2$ | 1 l/min |
| Pression | 0,067 bar |
| Température | 1030°C |
| Durée | 1 heure |

Des essais de tournage ont été effectués avec ces plaquettes dans les conditions suivantes:

Acier CK 60
Plaquette de coupe TNMM 22 04 12
Vitesse 200 m/min
Avance 0,4 mm
Profondeur de passe 2 mm

La durée de vie de chaque plaquette ainsi testée a été la suivante:

| | |
|---|---|
| Plaquette (A): | 6 min |
| Plaquette (B) (invention): | 15 min |

*Exemple 2*

Deux plaquettes de coupe standard ont été utilisées pour ce second essai, la plaquette (C) étant munie d'un revêtement formé de $TiC$-$TiN$-$Al_2O_3$, et la plaquette (D) étant munie d'un revêtement de même épaisseur totale formé des mêmes couches que celui de la plaquette (C), mais recouvert d'une couche d'oxyborure supérieur d'aluminium et d'une couche externe de borure supérieur d'aluminium. Des essais de tournage ont été effectués dans les conditions suivantes:

· Acier CK 60
Plaquette de coupe GNMM 22 04 12
Vitesse 200 m/min
Avance 0,4 mm
Profondeur de passe 4 mm

La durée de vie de chaque plaquette ainsi testée a été la suivante:

| Plaquette (C): | 13 min |
| Plaquette (D) (invention): | 18 min |

Il ressort donc des exemples ci-dessus que les caractéristiques de résistance à l'usure sont nettement améliorées avec les plaquettes selon l'invention, par rapport à celles munies d'un revêtement protecteur connu.

## Revendications

1. Pièce d'usure en matériau réfractaire, recouverte au moins aux endroits soumis à usure d'un revêtement protecteur, caractérisée par le fait que la couche externe du revêtement est constituée par au moins un composé de l'aluminium choisi parmi les borures supérieurs de formule $AlB_n$, où n = 10 ou 12, et les oxyborures supérieurs de formule $AlOB_m$, où m est égal ou supérieur à 8.

2. Pièce d'usure selon la revendication 1, caractérisée par le fait que l'épaisseur de la couche externe est comprise entre 0,5 et 10 $\mu$.

3. Pièce d'usure selon la revendication 1 ou 2, caractérisée par le fait que le revêtement protecteur est entièrement constitué par un ou plusieurs desdits borures supérieurs ou oxyborures supérieurs d'aluminium.

4. Pièce d'usure selon la revendication 1 ou 2, caractérisée par le fait que le revêtement protecteur comporte une ou plusieurs couches internes constituées par d'autres composés réfractaires, ou bien par les mêmes composés de l'aluminium que la couche externe.

5. Pièce d'usure selon la revendication 4, caractérisée par le fait que le revêtement est constitué par la superposition d'une couche de carbure de titane et d'une couche d'un oxyborure supérieur d'aluminium.

6. Pièce d'usure selon la revendication 4, caractérisée par le fait que le revêtement est constitué par la superposition des couches suivantes: carbure de titane, nitrure de titane, oxyde d'aluminium, oxyborure supérieur d'aluminium et borure supérieur d'aluminium.

7. Pièce d'usure selon l'une des revendications 1 à 6, caractérisée par le fait qu'elle consiste en un outil de coupe.

## Patentansprüche

1. Verschleissteil aus hitzebeständigem Material, das wenigstens an Verschleiss ausgesetzten Stellen mit einem Schutzüberzug versehen ist, dadurch gekennzeichnet, dass die äussere Schicht des Schutzüberzugs aus wenigstens einer Zusammensetzung von Aluminium besteht, die ausgewählt ist unter den höheren Boriden der Formel $AlB_n$, wobei n = 10 oder 12 ist, und unter den höheren Oxyboriden der Formel $AlOB_m$, wobei m gleich oder grösser als 8 ist.

2. Verschleissteil nach Anspruch 1, dadurch gekennzeichnet, dass die Dicke der äusseren Schicht 0,5 bis 10 $\mu$ beträgt.

3. Verschleissteil nach Anspruch 1 oder 2, dadurch gekennzeichnet, dass der Schutzüberzug vollständig aus einem oder mehreren der angegebenen höheren Boride oder höheren Oxyboride von Aluminium besteht.

4. Verschleissteil nach Anspruch 1 oder 2, dadurch gekennzeichnet, dass der Schutzüberzug eine oder mehrere innere Schichten aufweist, die aus weiteren hitzebeständigen Zusammensetzungen oder aus denselben Zusammensetzungen des Aluminiums wie die äussere Schicht bestehen.

5. Verschleissteil nach Anspruch 4, dadurch gekennzeichnet, dass der Überzug aus der Überlagerung einer Schicht aus Titancarbid und einer Schicht aus einem höheren Oxyborid von Aluminium besteht.

6. Verschleissteil nach Anspruch 4, dadurch gekennzeichnet, dass der Überzug aus der Überlagerung der folgenden Schichten besteht: Titancarbid, Titannitrid, Aluminiumoxid, höheres Oxyborid von Aluminium und höheres Borid von Aluminium.

7. Verschleissteil nach einem der Ansprüche 1 bis 6, dadurch gekennzeichnet, dass es aus einem Schneidwerkzeug besteht.

## Claims

1. Wear-resistant article of refractory material, which is covered at least on the places subjected to wear with a protecting coating, characterized by the fact that the external layer of the coating is constituted of at least an aluminium compound selected among the higher borides of formula $AlB_n$, where n = 10 or 12, and the higher oxyborides of formula $AlOB_m$, where m is equal or higher than 8.

2. Wear-resistant article according to claim 1, characterized by the fact that the thickness of the external layer is comprised between 0.5 and 10 $\mu$.

3. Wear-resistant article according to claim 1 or 2, characterized by the fact that the protecting coating is completely constituted by one or several of said aluminium higher borides or oxyborides.

4. Wear-resistant article according to claim 1 or 2, characterized by the fact that the protecting coating comprises one or several internal layers constituted by other refractory compounds, or by the same aluminium compounds as the external layer.

5. Wear-resistant article according to claim 4, characterized by the fact that the coating is constituted by the superposition of a titanium carbide layer and an aluminium higher oxyboride layer.

6. Wear-resistant article according to claim 4, characterized by the fact that the coating is constituted of the superposition of the following layers: titanium carbide, titanium nitride, aluminium oxide, aluminium higher oxyboride and aluminium higher boride.

7. Wear-resistant article according to one of claims 1 to 6, characterized by the fact that it consists in a cutting tool.